# EUROPÄISCHE PATENTANMELDUNG

(11) **EP 3 749 067 A1**
(43) Veröffentlichungstag der Anmeldung: **09.12.2020**
(21) Anmeldenummer: 20174460.4
(22) Anmeldetag: 13.05.2020
(51) Int. Cl.: H05K 1/02, H05K 3/46, H05K 3/04

(54) **VERFAHREN ZUM HERSTELLEN EINER SCHALTUNGSTRÄGERPLATTE UND SCHALTUNGSTRÄGERPLATTE**

(30) Priorität: 05.06.2019 DE 102019115111
(71) Anmelder: Marelli Automotive Lighting Reutlingen (Germany) GmbH, 72762 Reutlingen (DE)
(72) Erfinder: Schöning, Michael, 37154 Northeim (DE)
(74) Vertreter: DREISS Patentanwälte PartG mbB

(57) **Zusammenfassung**

Verfahren zum Herstellen einer Schaltungsträgerplatte mit einem einen Faserverbundwerkstoff aufweisenden Grundkörper, aufweisend die folgenden Schritte: Bereitstellen des Grundkörpers, Anfertigen wenigstens einer Öffnung in dem Grundkörper, Einbringen wenigstens eines Einsatzes in der wenigstens einen Öffnung so, dass zwischen wenigstens einer Seitenwand des Einsatzes und einer Seitenwand der Öffnung wenigstens ein Spalt verbleibt, Einbringen eines Füllmaterials in den wenigstens einen Spalt.

## Beschreibung

Die Offenbarung betrifft ein Verfahren zum Herstellen einer Schaltungsträgerplatte mit einem einen Faserverbundwerkstoff aufweisenden Grundkörper.

Die Offenbarung betrifft ferner eine Schaltungsträgerplatte mit einem einen Faserverbundwerkstoff aufweisenden Grundkörper.

Aus der DE 10 2004 059 986 A1 ist eine Wärmesenkenanordnung zum Dissipieren von Wärme von einer oder mehreren elektronischen Komponenten bekannt.

Bevorzugte Ausführungsformen beziehen sich auf ein Verfahren zum Herstellen einer Schaltungsträgerplatte mit einem einen Faserverbundwerkstoff aufweisenden Grundkörper, aufweisend die folgenden Schritte: Bereitstellen des Grundkörpers, Anfertigen wenigstens einer Öffnung in dem Grundkörper, Einbringen wenigstens eines Einsatzes in der wenigstens einen Öffnung so, dass zwischen wenigstens einer Seitenwand des Einsatzes und einer Seitenwand der Öffnung wenigstens ein Spalt verbleibt, Einbringen eines Füllmaterials in den wenigstens einen Spalt. Der wenigstens eine Spalt definiert z.B. einen Volumenbereich, der kein Material des Grundkörpers und/oder des Einsatzes aufweist, und der z.B. zumindest teilweise mit dem Füllmaterial gefüllt werden kann. Das Verfahren gemäß bevorzugten Ausführungsformen ermöglicht eine effiziente Herstellung von Schaltungsträgerplatten mit einem oder mehreren Einsätzen, die bevorzugt ein anderes Material bzw. andere Materialeigenschaften aufweisen können als das Material des Grundkörpers.

Bei weiteren bevorzugten Ausführungsformen ist vorgesehen, dass das Bereitstellen des Grundkörpers aufweist: Bereitstellen des Grundkörpers mit wenigstens einer primären elektrisch leitfähigen Schicht, die auf wenigstens einer Oberfläche des Grundkörpers angeordnet ist, wobei insbesondere die wenigstens eine primäre elektrisch leitfähige Schicht eine Kupferschicht ist.

Bei weiteren bevorzugten Ausführungsformen ist vorgesehen, dass die wenigstens eine primäre elektrisch leitfähige Schicht strukturiert ist. Mit anderen Worten kann der bereitgestellte Grundkörper bei weiteren bevorzugten Ausführungsformen bereits wenigstens eine strukturierte Kupferschicht (z.B. ein oder mehrere Leiterbahnen) aufweisen, bevor die wenigstens eine Öffnung angefertigt wird.

Bei weiteren bevorzugten Ausführungsformen ist vorgesehen, dass das Anfertigen der wenigstens einen Öffnung aufweist: Anfertigen einer polygonalen Öffnung mit abgerundeten Ecken, wobei die abgerundeten Ecken einen ersten Krümmungsradius aufweisen.

Bei weiteren bevorzugten Ausführungsformen ist vorgesehen, dass das Anfertigen der wenigstens einen Öffnung mittels eines spanenden Fertigungsverfahrens, insbesondere Fräsen oder Bohren, erfolgt.

Bei weiteren bevorzugten Ausführungsformen ist vorgesehen, dass das Verfahren weiter aufweist: Auswählen des Einsatzes, insbesondere gemäß wenigstens einem der nachfolgenden Kriterien: a) Höhe (bzw. Dicke) des Einsatzes, b) Größe und/oder Querschnittsform des Einsatzes, c) Krümmungsradius wenigstens einer Ecke des Einsatzes, d) Wärmeleitfähigkeit des Einsatzes, e) Oberflächenmerkmale (z.B. elektrisch leitfähige, insbesondere metallische, Beschichtung, z.B. auch strukturiert, insbesondere in Form von Leiterbahnen) des Einsatzes.

Bei weiteren bevorzugten Ausführungsformen ist vorgesehen, dass der Spalt eine Breite zwischen 0,0 Millimeter und 2,0 Millimeter aufweist, vorzugsweise zwischen 0,1 Millimeter und 0,4 Millimeter, weiter vorzugsweise zwischen 0,1 Millimeter und 0,2 Millimeter.

Bei weiteren bevorzugten Ausführungsformen ist vorgesehen, dass als Füllmaterial ein, insbesondere synthetisches, Harz, insbesondere Epoxidharz, verwendet wird.

Bei weiteren bevorzugten Ausführungsformen ist vorgesehen, dass das Einbringen des Füllmaterials wenigstens eines der folgenden Elemente aufweist: a) Dosieren des Füllmaterials in den wenigstens einen Spalt, insbesondere unter Normaldruck, b) Dosieren des Füllmaterials in den wenigstens einen Spalt unter geringerem Druck als dem Normaldruck, insbesondere unter Vakuum.

Bei weiteren bevorzugten Ausführungsformen ist vorgesehen, dass das Einbringen des wenigstens einen Einsatzes in der wenigstens einen Öffnung wenigstens eines der folgenden Elemente aufweist: a) Positionieren des wenigstens einen Einsatzes in der wenigstens einen Öffnung mittels eines Positioniersystems, b) Positionieren des wenigstens einen Einsatzes in der wenigstens einen Öffnung mittels Rütteln.

Bei weiteren bevorzugten Ausführungsformen ist vorgesehen, dass das Verfahren weiter aufweist: zumindest teilweises Abtragen des eingebrachten Füllmaterials.

Bei weiteren bevorzugten Ausführungsformen ist vorgesehen, dass das Verfahren weiter aufweist: Anordnen wenigstens einer sekundären elektrisch leitfähigen Schicht (z.B. Kupferschicht) auf wenigstens einer Oberfläche der Schaltungsträgerplatte und/oder des Einsatzes. Bei weiteren bevorzugten Ausführungsformen ist die wenigstens eine sekundäre elektrisch leitfähige Schicht strukturierbar, z.B. zur Ausbildung von elektrischen Leiterbahnen und/oder sonstigen Strukturen.

Bei weiteren bevorzugten Ausführungsformen ist vorgesehen, dass der wenigstens eine Einsatz wenigstens ein Material mit einer Wärmeleitfähigkeit aufweist, die größer ist als die Wärmeleitfähigkeit des Grundkörpers, insbesondere wenigstens ein Keramikmaterial, vorzugsweise aufweisend Aluminiumnitrid. Weiter bevorzugt ist das Füllmaterial nicht elektrisch leitfähig.

Weitere bevorzugte Ausführungsformen beziehen sich auf eine Schaltungsträgerplatte mit einem einen Faserverbundwerkstoff aufweisenden Grundkörper, wobei der Grundkörper wenigsten eine Öffnung aufweist, wobei in der wenigstens einen Öffnung wenigstens ein Einsatz so angeordnet ist, dass zwischen wenigstens einer Seitenwand des Einsatzes und einer Seitenwand der Öffnung wenigstens ein Spalt verbleibt, wobei in dem wenigstens einen Spalt zumindest bereichsweise ein Füllmaterial angeordnet ist.

Bei weiteren bevorzugten Ausführungsformen ist vorgesehen, dass a) der Spalt eine Breite zwischen 0,0 Millimeter und 2,0 Millimeter aufweist, vorzugsweise zwischen 0,1 Millimeter und 0,4 Millimeter, weiter vorzugsweise zwischen 0,1 Millimeter und 0,2 Millimeter und/oder b) das Füllmaterial ein, insbesondere synthetisches, Harz, insbesondere Epoxidharz, ist.

Bei weiteren bevorzugten Ausführungsformen ist vorgesehen, dass die wenigstens eine Öffnung eine polygonale Grundform mit abgerundeten Ecken aufweist, wobei die abgerundeten Ecken einen ersten Krümmungsradius aufweisen, wobei der wenigstens eine Einsatz eine polygonale Grundform mit Ecken aufweist, wobei wenigstens eine Ecke des Einsatzes einen zweiten Krümmungsradius aufweist, der kleiner ist als der erste Krümmungsradius. Bei weiteren bevorzugten Ausführungsformen ist der zweite Krümmungsradius kleiner als 10 Prozent des ersten Krümmungsradius. Dadurch kann der genannte wenigstens eine Spalt besonders präzise definiert werden.

Weitere bevorzugte Ausführungsformen beziehen sich auf eine Verwendung der Schaltungsträgerplatte gemäß den Ausführungsformen a) zur Aufnahme von wenigstens einer Wärmequelle, wobei die Wärmequelle wenigstens ein elektrisches bzw. elektronisches Bauelement aufweist, und b) zur Entwärmung des wenigstens einen Bauelements.

Weitere Merkmale, Anwendungsmöglichkeiten und Vorteile weiterer bevorzugter Ausführungsformen ergeben sich aus der nachfolgenden Beschreibung und den Figuren der Zeichnung. Dabei bilden alle beschriebenen und dargestellten Merkmale für sich oder in beliebiger Kombination den Gegenstand der Erfindung, unabhängig von den Patentansprüchen oder deren Rückbeziehung sowie unabhängig von Ihrer Formulierung bzw. Darstellung in der Beschreibung bzw. in der Zeichnung.

In der Zeichnung zeigt:
- Fig. 1: schematisch ein vereinfachtes Flussdiagramm eines Verfahrens gemäß bevorzugten Ausführungsformen,
- Fig. 2: schematisch eine Draufsicht auf eine Schaltungsträgerplatte gemäß weiteren bevorzugten Ausführungsformen,
- Fig. 3: ein Detail der Schaltungsträgerplatte aus Fig. 2 mit einem Einsatz gemäß weiteren bevorzugten Ausführungsformen,
- Fig. 4A, 4B, 4C: jeweils schematisch eine Seitenansicht einer Schaltungsträgerplatte in unterschiedlichen Zuständen gemäß weiteren bevorzugten Ausführungsformen in teilweisem Querschnitt,
- Fig. 5: schematisch eine Seitenansicht einer Schaltungsträgerplatte gemäß weiteren bevorzugten Ausführungsformen in teilweisem Querschnitt,
- Fig. 6: schematisch eine Seitenansicht eines Einsatzes gemäß weiteren bevorzugten Ausführungsformen im Querschnitt,
- Fig. 7: schematisch ein vereinfachtes Flussdiagram eines Verfahrens gemäß weiteren bevorzugten Ausführungsformen,
- Fig. 8: schematisch ein vereinfachtes Flussdiagram eines Verfahrens gemäß weiteren bevorzugten Ausführungsformen, und
- Fig. 9: schematisch eine Seitenansicht einer Schaltungsträgerplatte gemäß weiteren bevorzugten Ausführungsformen.

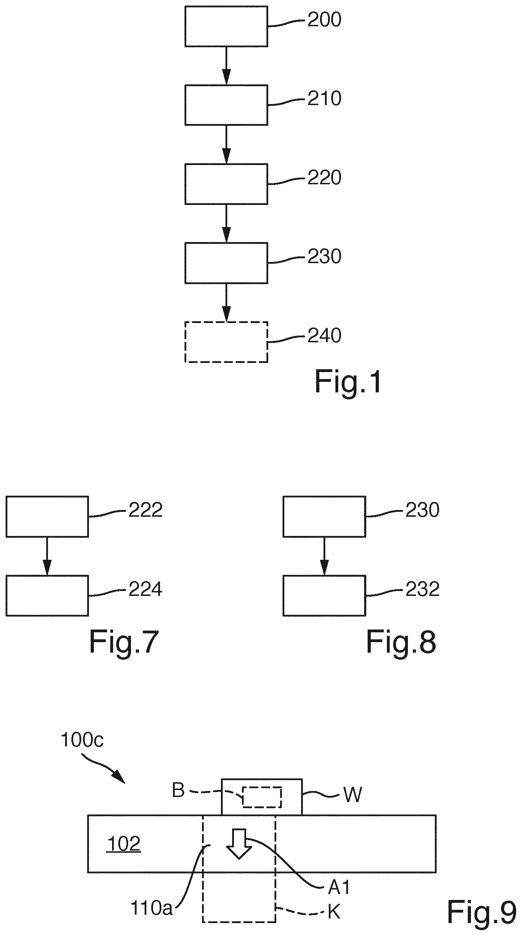

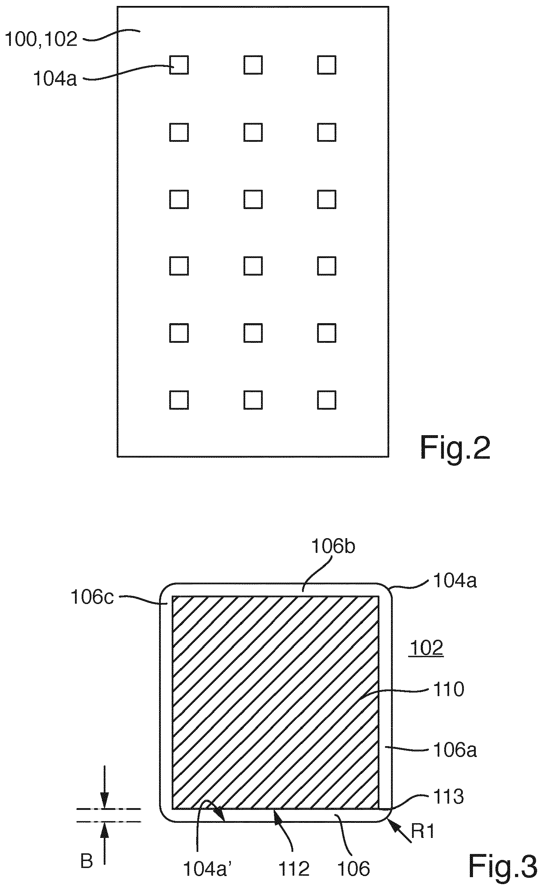

Figur 1 zeigt schematisch ein vereinfachtes Flussdiagramm eines Verfahrens zum Herstellen einer Schaltungsträgerplatte mit einem einen Faserverbundwerkstoff aufweisenden Grundkörper gemäß bevorzugten Ausführungsformen. Figur 2 zeigt hierzu beispielhaft eine Draufsicht auf eine derartige Schaltungsträgerplatte 100, und Figur 3 zeigt eine Detailansicht der Schaltungsträgerplatte 100 gemäß Figur 2.

Das Verfahren, vgl. Fig. 1, weist die folgenden Schritte auf: Bereitstellen 200 des Grundkörpers 102 (Fig. 2), Anfertigen 210 (Fig. 1) wenigstens einer Öffnung 104a (Fig. 2) in dem Grundkörper 102, Einbringen 220 (Fig. 1) wenigstens eines Einsatzes 110 (vgl. Fig. 3) in der wenigstens einen Öffnung 104a so, dass zwischen wenigstens einer Seitenwand 112 des Einsatzes 110 und einer Seitenwand 104a' der Öffnung 104a wenigstens ein Spalt 106 verbleibt. Der wenigstens eine Spalt 106 definiert z.B. einen Volumenbereich, der kein Material des Grundkörpers 102 und/oder des Einsatzes 110 aufweist (sondern z.B. ein umgebendes Medium wie z.B. Luft), und der z.B. zumindest teilweise mit einem Füllmaterial gefüllt werden kann. Bei dem Beispiel aus Figur 3 ergeben sich u.a. aufgrund der Geometrie der Öffnung 104a und des Einsatzes 110 vorliegend beispielhaft vier Spalte 106, 106a, 106b, 106c.

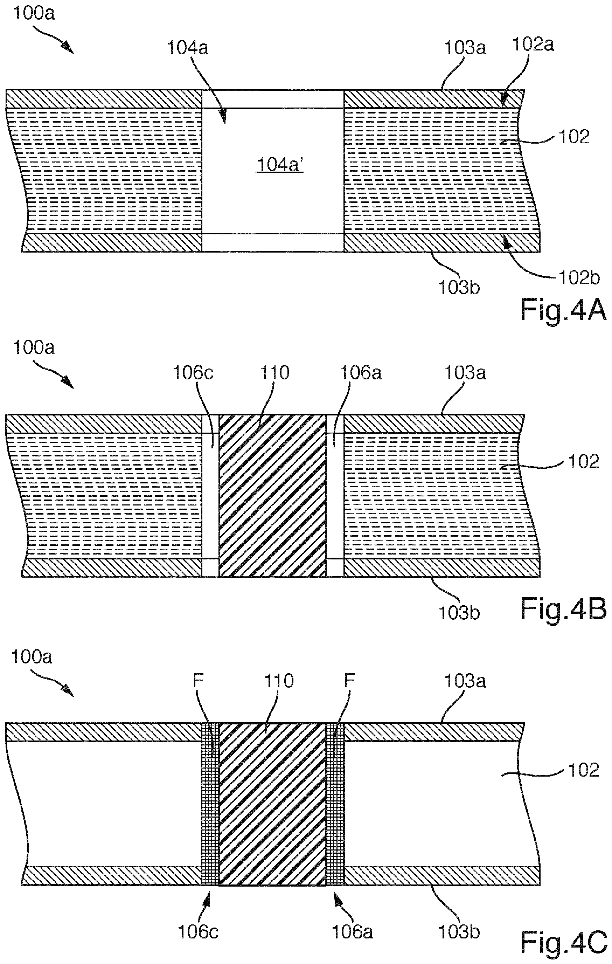

Nach dem Einbringen 220 des Einsatzes 110 kann ein nicht in Fig. 1 bis 3 abgebildetes Füllmaterial in den wenigstens einen Spalt 106, 106a, 106b, 106c eingebracht werden, vgl. Schritt 230 aus Fig. 1. Das Füllmaterial F ist nachstehend unter Bezugnahme auf Fig. 4A bis 4C näher beschrieben.

Das Verfahren gemäß bevorzugten Ausführungsformen ermöglicht eine effiziente Herstellung von Schaltungsträgerplatten 100 mit einem oder mehreren Einsätzen 110, die bevorzugt ein anderes Material bzw. andere Materialeigenschaften (z.B. Wärmeleitfähigkeit) aufweisen können als das Material des Grundkörpers 102 (Fig. 2). Die beispielhaft in Fig. 2 abgebildete Schaltungsträgerplatte 100 weist vorliegend insgesamt 18 Öffnungen auf, organisiert in Matrixform mit drei Spalten und sechs Zeilen, wobei aus Gründen der Übersichtlichkeit nur eine Öffnung mit dem Bezugszeichen 104a bezeichnet ist. Bei weiteren bevorzugten Ausführungsformen kann auch eine abweichende Anzahl und/oder Anordnung von Öffnungen in dem Grundkörper 102 der Schaltungsträgerplatte 100 vorgesehen werden, insbesondere eine oder mehr als eine Öffnung 104a.

Bei weiteren bevorzugten Ausführungsformen ist vorgesehen, dass das Bereitstellen 200 (Fig. 1) des Grundkörpers aufweist: Bereitstellen des Grundkörpers 102 (Fig. 2) mit wenigstens einer primären elektrisch leitfähigen Schicht, die auf wenigstens einer Oberfläche des Grundkörpers 102 angeordnet ist, wobei insbesondere die wenigstens eine primäre elektrisch leitfähige Schicht eine Kupferschicht ist. Bei weiteren bevorzugten Ausführungsformen kann der Grundkörper 102 in dem Schritt 200 beispielsweise in Form eines doppelseitig kupferkaschierten Kerns bereitgestellt werden, wobei der Kern z.B. den genannten Faserverbundwerkstoff aufweist, bei dem es sich weiteren bevorzugten Ausführungsformen zufolge beispielsweise um ein FR4-Material (Verbundwerkstoff aus Epoxidharz und Glasfasergewebe) handeln kann. Figur 4A zeigt beispielhaft eine Seitenansicht einer derartigen Schaltungsträgerplatte 100a in teilweisem Querschnitt, die als Grundkörper 102 einen Kern aus FR4-Material aufweist, auf dessen Oberflächen 102a, 102b vorliegend beispielhaft zwei Kupferschichten 103a, 103b angeordnet sind.

Bei weiteren bevorzugten Ausführungsformen ist vorgesehen, dass die wenigstens eine primäre elektrisch leitfähige Schicht, z.B. Kupferschicht 103a, 103b, strukturiert ist. Beispielsweise kann wenigstens ein der Kupferschichten 103a, 103b eine Strukturierung derart aufweisen, dass elektrische Leiterbahnen in der Schicht 103a, 103b vorgesehen sind, die dazu ausgebildet sind, auf der Schaltungsträgerplatte 100a anzuordnende elektrische und/oder elektronische Bauteile (nicht gezeigt) bzw. deren Anschlüsse elektrisch leitend miteinander zu verbinden. Mit anderen Worten können bei weiteren bevorzugten Ausführungsformen bei dem Schritt 200 (Fig. 1) des Bereitstellens bereits Leiterbahnstrukturen und/oder andere Strukturen (im Gegensatz z.B. zu einer homogenen Metallschicht) in einer oder mehreren der Kupferschichten 103a, 103b vorgesehen sein, was beispielsweise durch dem Schritt 200 vorangehende Bearbeitungsschritte erfolgen kann.

Bei weiteren bevorzugten Ausführungsformen kann eine Strukturierung der Kupferschichten 103a, 103b alternativ zumindest teilweise auch vor und/oder nach dem Anfertigen 210 (Fig. 1) der wenigstens einen Öffnung 104a erfolgen.

Bei weiteren bevorzugten Ausführungsformen ist vorgesehen, dass das Anfertigen 210 der wenigstens einen Öffnung aufweist: Anfertigen einer polygonalen Öffnung mit abgerundeten Ecken, wobei die abgerundeten Ecken einen ersten Krümmungsradius aufweisen. Dies ist beispielhaft in dem Detail aus Fig. 3 gezeigt, bei dem die Öffnung 104a eine Rechteckform, insbesondere Quadratform, aufweist, wobei die Ecken der Quadratform einen ersten Krümmungsradius R1 aufweisen.

Bei weiteren bevorzugten Ausführungsformen sind auch andere polygonale Formen oder auch nicht-polygonale Formen (z.B. Kreis, Ellipse oder beliebige Kurvenform) für wenigstens eine Öffnung in dem Grundkörper 102 zur Aufnahme wenigstens eines Einsatzes denkbar. Auch hierbei kann bei entsprechender Formgebung wenigstens ein Spalt zwischen dem Grundkörper und dem betreffenden Einsatz definiert werden.

Insbesondere kann der Spalt 106, der bei dem Beispiel nach Fig. 3 z.B. zumindest in etwa Quaderform aufweist, definiert durch eine Breite B, eine nicht bezeichnete Länge (z.B. entsprechend einer Kantenlänge des Einsatzes 110 in der Zeichenebene der Fig. 3) und eine senkrecht zur Zeichenebene der Fig. 3 betrachtete Dicke des Grundkörpers 102, weiteren bevorzugten Ausführungsformen zufolge auch eine von der Quaderform abweichende Form aufweisen, insbesondere auch gekrümmte Bereiche, z.B. konvexe oder konkave Begrenzungsflächen, aufweisen.

Bei weiteren bevorzugten Ausführungsformen ist vorgesehen, dass das Anfertigen 210 (Fig. 1) der wenigstens einen Öffnung 104a (Fig. 3) mittels eines spanenden Fertigungsverfahrens, insbesondere mittels Fräsen, erfolgt. Durch die Auswahl eines Außendurchmessers eines für das Fräsen 210 der Öffnung 104a verwendeten Fräswerkzeugs bzw. Fräskopfes lässt sich bei weiteren bevorzugten Ausführungsformen vorteilhaft der erste Krümmungsradius R1 beeinflussen. Alternativ oder ergänzend kann auch ein anderes spanendes Fertigungsverfahren verwendet werden, z.B. Bohren.

Bei weiteren bevorzugten Ausführungsformen, vgl. auch das Flussdiagramm aus Figur 7, ist vorgesehen, dass das Verfahren weiter aufweist: Auswählen 222 des Einsatzes 110 (Fig. 3), insbesondere gemäß wenigstens einem der nachfolgenden Kriterien: a) Dicke bzw. Höhe des Einsatzes 110 (senkrecht zur Zeichenebene der Fig. 3), b) Größe und/oder Querschnittsform des Einsatzes 110, c) Krümmungsradius wenigstens einer Ecke 113 des Einsatzes 110, d) Wärmeleitfähigkeit des Einsatzes 110, e) Oberflächenmerkmale des Einsatzes 110. Nach dem Auswählen 222 kann der Einsatz 110 wie vorstehend bereits unter Bezugnahme auf Fig. 1 beschrieben in die wenigstens eine Öffnung 104a des Grundkörpers 102 (Fig. 2) eingebracht werden, vgl. Schritt 224 aus Fig. 7.

Bei weiteren bevorzugten Ausführungsformen können auch mehrere Einsätze 110 mit z.B. jeweils unterschiedlichen Eigenschaften, z.B. entsprechend wenigstens einem der vorstehend genannten Kriterien a), b), c), d), e), vorgehalten werden (z.B. Vorsortierung mehrerer Einsätze nach ihrer Dicke), z.B. für den Schritt 222 des Auswählens.

Durch das Auswählen der Dicke bzw. Höhe des Einsatzes 110 kann bei weiteren bevorzugten Ausführungsformen beeinflusst werden, ob der Einsatz 110 z.B. bündig bzw. nicht bündig mit einer oder mehreren Außenoberflächen 102a, 102b (Fig. 4A) des Grundkörpers 102 bzw. der Schaltungsträgerplatte (ggf. zuzüglich der Dicke optionaler Schichten 103a, 103b) ist.

Durch das Auswählen der Größe und/oder Querschnittsform des Einsatzes 110 kann bei weiteren bevorzugten Ausführungsformen z.B. die Anzahl von Spalten 106, 106a, 106b, 106c (Fig. 3) zwischen den Wänden 112, 104a' beeinflusst werden und/oder die Breite B bzw. allgemein eine Geometrie des betreffenden Spalts.

Durch das Auswählen des Krümmungsradius der wenigstens einen Ecke 113 des Einsatzes 110 kann bei weiteren bevorzugten Ausführungsformen auch die Breite B des Spalts bzw. ein Bedeckungsgrad beeinflusst werden, der charakterisiert, welcher Anteil der Fläche der Öffnung 104a durch den Einsatz 110 bedeckt wird, was sich z.B. auch auf ein Volumen des Spalts bzw. der Spalte auswirken kann und damit auf einen Bedarf an Füllmaterial für den Schritt 230 (Fig. 1) des Einbringens des Füllmaterials in den/die Spalte.

Durch das Auswählen der Oberflächenmerkmale des Einsatzes 110 kann bei weiteren bevorzugten Ausführungsformen z.B. festgelegt werden, welche Funktion(en) der Einsatz 110 in der Schaltungsträgerplatte ermöglicht. Beispielsweise kann bei manchen Ausführungsformen, bei denen eine Entwärmung eines Bauteils mittels des Einsatzes bewirkt werden soll, ausreichend sein, einen Einsatz 110 mit einem hinreichend gut wärmeleitfähigem Material bzw. einer entsprechenden Oberfläche vorzusehen, die eine thermisch gut leitende Anbindung an das zu entwärmende Bauteil ermöglicht.

Demgegenüber kann bei weiteren bevorzugten Ausführungsformen vorgesehen sein, dass wenigstens eine Oberfläche des Einsatzes 110 eine elektrisch leitende Schicht, z.B. Metallschicht, insbesondere Kupferschicht, aufweist, die bei weiteren bevorzugten Ausführungsformen z.B. auch zumindest bereichsweise strukturiert sein kann, beispielsweise um ein oder mehrere elektrische Leiterbahnen bereitzustellen.

Bei weiteren bevorzugten Ausführungsformen ist vorgesehen, dass der Spalt 106 (Fig. 3) eine Breite B zwischen 0,0 Millimeter und 2,0 Millimeter aufweist, vorzugsweise zwischen 0,1 Millimeter und 0,4 Millimeter, weiter vorzugsweise zwischen 0,1 Millimeter und 0,2 Millimeter. Die Breite B kann bei weiteren bevorzugten Ausführungsformen beispielsweise durch eine Auswahl der Größe und/oder des Krümmungsradius der Ecken 113 des Einsatzes 110 in Bezug auf die Größe und/oder den ersten Krümmungsradius R1 der bevorzugt abgerundeten Ecken der Öffnung 104a beeinflusst werden.

Bei weiteren bevorzugten Ausführungsformen ist vorgesehen, dass als Füllmaterial ein, insbesondere synthetisches, Harz, insbesondere Epoxidharz, verwendet wird. Die Figuren 4A bis 4C zeigen hierzu schematisch unterschiedliche Zustände der Schaltungsträgerplatte 100a, wie sie sich bei der Abfolge der Schritte 200, 210, 220, 230 (Fig. 1) gemäß bevorzugten Ausführungsformen ergeben.

Figur 4A zeigt einen Zustand, bei dem eine Öffnung 104a in dem Grundkörper 102 angefertigt worden ist, vgl. Schritt 210 aus Figur 1.

Figur 4B zeigt einen Zustand, bei dem der Einsatz 110 in die Öffnung 104a eingebracht worden ist, vgl. Schritt 220 aus Figur 1. Vorliegend ist die Dicke bzw. Höhe (entlang einer vertikalen Koordinate der Fig. 4B) des Einsatzes 110 so gewählt, dass sie zumindest in etwa der Dicke der Schaltungsträgerplatte 100a entspricht. Zusätzlich sind aus Fig. 4B zwei Spalte 106a, 106c ersichtlich, vgl. auch die Draufsicht aus Fig. 3.

Figur 4C zeigt einen Zustand, bei dem das Füllmaterial F in die Spalte 106a, 106c (und bevorzugt auch in die weiteren Spalte 106, .., 106c, vgl. Fig. 3) eingebracht worden ist, vgl. Schritt 230 aus Fig. 1, was vorliegend derart erfolgt ist, dass ein durch die Spalte definierter Volumenbereich zwischen den Seitenwänden 104a' (Fig. 4A), 112 (Fig. 3) i.w. vollständig mit dem Füllmaterial F ausgefüllt worden ist. Bei weiteren Ausführungsformen kann Schritt 230 auch zum Gegenstand haben, einen oder mehrere der Spalte 106, .., 106c nur teilweise mit dem Füllmaterial F zu füllen bzw. sie zu überfüllen.

Bei weiteren bevorzugten Ausführungsformen ist vorgesehen, dass das Einbringen 230 (Fig. 1) des Füllmaterials F (Fig. 4C) wenigstens eines der folgenden Elemente aufweist: a) Dosieren des Füllmaterials F in den wenigstens einen Spalt, insbesondere unter Normaldruck, b) Dosieren des Füllmaterials in den wenigstens einen Spalt unter geringerem Druck als dem Normaldruck, insbesondere unter Vakuum bzw. einem vorgebbaren Unterdruck, wobei vorteilhaft der Kapillareffekt nutzbar ist.

Bei weiteren bevorzugten Ausführungsformen ist vorgesehen, dass das Einbringen 220 (Fig. 1) des wenigstens einen Einsatzes 110 (Fig. 4C) in der wenigstens einen Öffnung wenigstens eines der folgenden Elemente aufweist: a) Positionieren des wenigstens einen Einsatzes 110 in der wenigstens einen Öffnung mittels eines Positioniersystems (nicht gezeigt), b) Positionieren des wenigstens einen Einsatzes in der wenigstens einen Öffnung mittels Rütteln und/oder in sonstiger Weise schwerkraftunterstützt.

Bei weiteren bevorzugten Ausführungsformen, vgl. das Flussdiagramm aus Fig. 8, ist vorgesehen, dass das Verfahren aufweist: Einbringen 230 des Füllmaterials F (Fig. 4C), zumindest teilweises Abtragen 232 (Fig. 8) des eingebrachten Füllmaterials. Beispielsweise kann bei weiteren bevorzugten Ausführungsformen eine vorgebbare Überfüllung des wenigstens einen Spalts 106 erwünscht sein, z.B. zum Ausgleichen einer ggf. auftretenden Schrumpfung bei einem ggf. erforderlichen Härten des Füllmaterials F, wobei ein übermäßiger Auftrag von Füllmaterial F nachträglich durch den Schritt des Abtragens 232 korrigiert bzw. kompensiert werden kann.

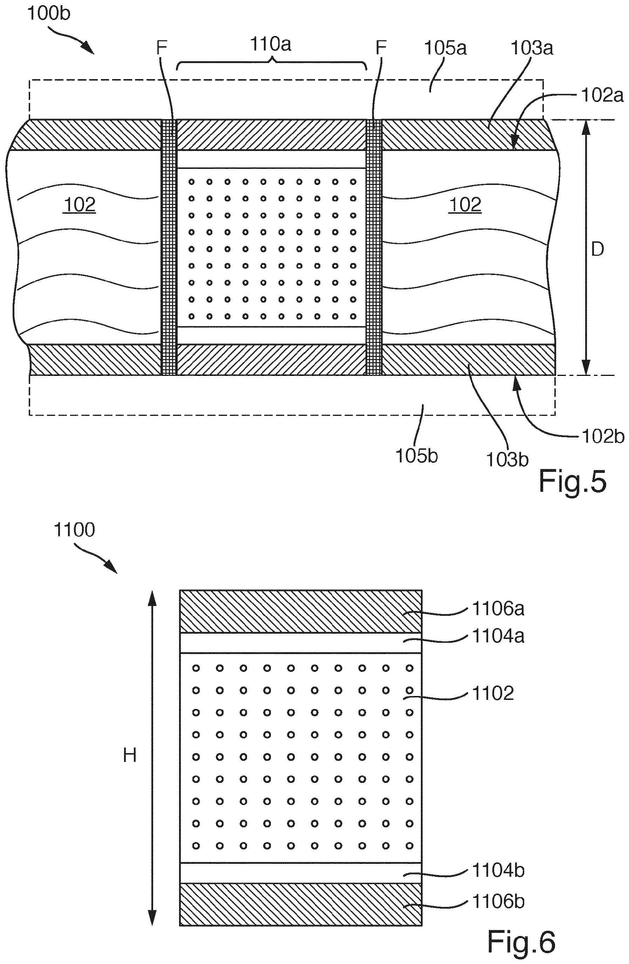

Figur 5 zeigt schematisch eine Seitenansicht einer Schaltungsträgerplatte 100b gemäß weiteren bevorzugten Ausführungsformen in teilweisem Querschnitt. Die Höhe des Einsatzes 110a ist so auf die Dicke D der Schaltungsträgerplatte 100b (einschließlich optionaler Metallschichten wie z.B. Kupferlagen 103a, 103b) abgestimmt, dass der Einsatz 110a bündig mit den vorliegend nicht bezeichneten Außenoberflächen der Kupferlagen 103a, 103b abschließt.

Weiter weist die Schaltungsträgerplatte 100b wenigstens eine optionale sekundäre elektrisch leitfähige Schicht 105a, 105b, z.B. ebenfalls eine Kupferschicht, auf wenigstens einer ihrer Oberflächen auf, die bei weiteren bevorzugten Ausführungsformen beispielsweise in einem optionalen Schritt 240 (Fig. 1) des Anordnens (z.B. "Plating"-Prozess) der Schicht(en) 105a, 105b, bevorzugt nach dem Einbringen 230 des Füllmaterials F (und einem ggf. erfolgenden Abtragen, vgl. Schritt 232 aus Fig. 8) vorgesehen wird.

Figur 6 zeigt schematisch eine Seitenansicht eines Einsatzes 1100 gemäß weiteren bevorzugten Ausführungsformen im Querschnitt. Beispielsweise kann der Einsatz 110 gemäß Fig. 3, 4B, 4C und/oder der Einsatz 110a gemäß Fig. 5 die in Figur 6 abgebildete Konfiguration aufweisen.

Der Einsatz 1100 weist wenigstens ein Material, z.B. einen Kern 1102, mit einer Wärmeleitfähigkeit auf, die größer ist als die Wärmeleitfähigkeit des Grundkörpers 102 (z.B. FR4-Material), wobei das Material 1102 insbesondere ein Keramikmaterial ist, z.B. Aluminiumnitrid (AlN)-Keramik.

Bei weiteren bevorzugten Ausführungsformen kann der Einsatz 1100 wenigstens eine Haftschicht 1104a, 1104b aufweisen. Bevorzugt ist eine in Fig. 6 obere Außenoberfläche des Kerns 1102 und eine in Fig. 6 untere Außenoberfläche des Kerns 1102 mit einer entsprechenden Haftschicht ("Treatment") versehen, die das zuverlässige Anhaften der optionalen weiteren Metallschichten, z.B. Kupferlagen 1106a, 1106b, ermöglicht.

Damit weist der Einsatz 1100 die durch den AlN-Keramikkern 1102 bedingte vergleichsweise große thermische Leitfähigkeit auf sowie elektrisch leitende Oberflächen 1106a, 1106b, die eine effiziente thermisch und/oder elektrisch leitfähige Anbindung an ein oder mehrere weitere Komponenten ermöglicht.

Bevorzugt ist die Geometrie, insbesondere Schichtdicke, der jeweiligen "Schicht" 1106a, 1104a, 1102, 1104b, 1106b so gewählt, dass die gesamte Höhe H des Einsatzes 1100 z.B. zumindest i.w. der Dicke D (Fig. 5) der Schaltungsträgerplatte 100b entspricht, wodurch der Einsatz 1100 (Fig. 6) oberflächenbündig in die Öffnung in dem Grundkörper 102 integriert werden kann.

Weitere bevorzugte Ausführungsformen beziehen sich auf eine Schaltungsträgerplatte mit einem einen Faserverbundwerkstoff (z.B. FR-4 Material) aufweisenden Grundkörper 102 (Fig. 4A), wobei der Grundkörper 102 wenigstens eine Öffnung 104a (Fig. 2) aufweist, wobei in der wenigstens einen Öffnung 104a wenigstens ein Einsatz 110 (Fig. 4B) so angeordnet ist, dass zwischen wenigstens einer Seitenwand des Einsatzes und einer Seitenwand der Öffnung wenigstens ein Spalt 106, 106a, 106b, 106c (Fig. 3) verbleibt, wobei in dem wenigstens einen Spalt 106, 106a, 106b, 106c zumindest bereichsweise ein Füllmaterial F (Fig. 4C) angeordnet ist.

Bei weiteren bevorzugten Ausführungsformen ist vorgesehen, dass a) der Spalt eine Breite B (Fig. 3) zwischen 0,0 Millimeter und 2,0 Millimeter aufweist, vorzugsweise zwischen 0,1 Millimeter und 0,4 Millimeter, weiter vorzugsweise zwischen 0,1 Millimeter und 0,2 Millimeter.

Weitere bevorzugte Ausführungsformen beziehen sich auf eine Verwendung der Schaltungsträgerplatte gemäß den Ausführungsformen zur Aufnahme von wenigstens einer Wärmequelle, wobei die Wärmequelle wenigstens ein elektrisches bzw. elektronisches Bauelement aufweist, und zur Entwärmung des wenigstens einen Bauelements. Hierzu zeigt Figur 9 schematisch eine Seitenansicht. Auf der Schaltungsträgerplatte 100c, die vorliegend einen Einsatz 110a gemäß den Ausführungsformen aufweist, z.B, mit der Konfiguration 1100 nach Fig. 6, ist eine Wärmequelle W angeordnet, die ein elektronisches Bauelement B aufweist. Beispielsweise ist das elektronische Bauelement B ein optoelektronisches Bauelement, z.B. eine Leuchtdiode. Das Bauelement B ist im Bereich des Einsatzes 110a derart auf einer ersten Außenoberfläche der Schaltungsträgerplatte 100c angeordnet, dass eine effiziente Entwärmung durch die Schaltungsträgerplatte 100c bzw. ihren Einsatz 110a hindurch, in Fig. 9 vertikal nach unten, gegeben ist, vgl. den Blockpfeil A1. Auf einer der ersten Außenoberfläche der Schaltungsträgerplatte 100c gegenüberliegenden zweiten Außenoberfläche der Schaltungsträgerplatte 100c kann bei weiteren bevorzugten Ausführungsformen z.B. ein Kühlkörper K und/oder eine sonstige Wärmesenke vorgesehen sein.

Das Prinzip gemäß den Ausführungsformen ermöglicht eine effiziente Herstellung von z.B. doppelseitig kupferkaschierten Schaltungsträgerplatten mit einem oder mehreren hochwärmeleitfähigen Einsätzen 110, 110a, 1100, die insbesondere für eine Aufnahme (z.B. mechanische Befestigung) und/oder elektrische Kontaktierung von Bauelementen B und eine effiziente transversale (durch den Grundkörper 102 hindurch erfolgende) Entwärmung der Bauelemente B nutzbar sind.
Bei weiteren bevorzugten Ausführungsformen kann der optionale Schritt 240 (Fig. 1) des Anordnens auch wenigstens eines der folgenden Elemente aufweisen: a) Schleifen, insbesondere Planschleifen, der Schaltungsträgerplatte 100b (Fig. 5) und/oder des Einsatzes 110a, b) Aufkupfern, insbesondere so, dass eine, vorzugsweise durchgehende, Verbindung zwischen der primären elektrisch leitfähigen Schicht 103a und der Metallschicht 1106a, z.B. Kupferlage 1106a, hergestellt wird.

## Patentansprüche

1. Verfahren zum Herstellen einer Schaltungsträgerplatte (100; 100a; 100b; 100c) mit einem einen Faserverbundwerkstoff aufweisenden Grundkörper (102), aufweisend die folgenden Schritte: Bereitstellen (200) des Grundkörpers (102), Anfertigen (210) wenigstens einer Öffnung (104a) in dem Grundkörper (102), Einbringen (220; 224) wenigstens eines Einsatzes (110; 110a) in der wenigstens einen Öffnung (104a) so, dass zwischen wenigstens einer Seitenwand (112) des Einsatzes (110; 110a) und einer Seitenwand (104a') der Öffnung (104a) wenigstens ein Spalt (106, 106a, 106b, 106c) verbleibt, Einbringen (230) eines Füllmaterials (F) in den wenigstens einen Spalt (106, 106a, 106b, 106c) .

2. Verfahren nach Anspruch 1, wobei das Bereitstellen (200) des Grundkörpers (102) aufweist: Bereitstellen des Grundkörpers (102) mit wenigstens einer primären elektrisch leitfähigen Schicht (103a, 103b), die auf wenigstens einer Oberfläche (102a, 102b) des Grundkörpers (102) angeordnet ist, wobei insbesondere die wenigstens eine primäre elektrisch leitfähige Schicht (103a, 103b) eine Kupferschicht ist.

3. Verfahren nach Anspruch 2, wobei die wenigstens eine primäre elektrisch leitfähige Schicht (103a, 103b) strukturiert ist.

4. Verfahren nach wenigstens einem der vorstehenden Ansprüche, wobei das Anfertigen (210) der wenigstens einen Öffnung (104a) aufweist: Anfertigen einer polygonalen Öffnung (104a) mit abgerundeten Ecken, wobei die abgerundeten Ecken einen ersten Krümmungsradius (R1) aufweisen.

5. Verfahren nach Anspruch 4, wobei das Anfertigen (210) der wenigstens einen Öffnung (104a) mittels eines spanenden Fertigungsverfahrens, insbesondere Fräsen, erfolgt.

6. Verfahren nach wenigstens einem der vorstehenden Ansprüche, weiter aufweisend: Auswählen (222) des Einsatzes (110; 110a), insbesondere gemäß wenigstens einem der nachfolgenden Kriterien: a) Höhe (H) des Einsatzes (110; 110a), b) Größe und/oder Querschnittsform des Einsatzes (110; 110a), c) Krümmungsradius wenigstens einer Ecke (113) des Einsatzes (110; 110a), d) Wärmeleitfähigkeit des Einsatzes (110; 110a), e) Oberflächenmerkmale des Einsatzes (110; 110a).

7. Verfahren nach wenigstens einem der vorstehenden Ansprüche, wobei der wenigstens eine Spalt (106, 106a, 106b, 106c) eine Breite (B) zwischen 0,0 Millimeter und 2,0 Millimeter aufweist, vorzugsweise zwischen 0,1 Millimeter und 0,4 Millimeter, weiter vorzugsweise zwischen 0,1 Millimeter und 0,2 Millimeter.

8. Verfahren nach wenigstens einem der vorstehenden Ansprüche, wobei als Füllmaterial (F) ein, insbesondere synthetisches, Harz, insbesondere Epoxidharz, verwendet wird.

9. Verfahren nach wenigstens einem der vorstehenden Ansprüche, wobei das Einbringen (230) des Füllmaterials (F) wenigstens eines der folgenden Elemente aufweist: a) Dosieren des Füllmaterials (F) in den wenigstens einen Spalt (106, 106a, 106b, 106c), insbesondere unter Normaldruck, b) Dosieren des Füllmaterials (F) in den wenigstens einen Spalt (106, 106a, 106b, 106c) unter geringerem Druck als dem Normaldruck, insbesondere unter Vakuum.

10. Verfahren nach wenigstens einem der vorstehenden Ansprüche, wobei das Einbringen (220; 224) des wenigstens einen Einsatzes (110; 110a) in der wenigstens einen Öffnung (104a) wenigstens eines der folgenden Elemente aufweist: a) Positionieren des wenigstens einen Einsatzes (110; 110a) in der wenigstens einen Öffnung (104a) mittels eines Positioniersystems, b) Positionieren des wenigstens einen Einsatzes (110; 110a) in der wenigstens einen Öffnung (104a) mittels Rütteln.

11. Verfahren nach wenigstens einem der vorstehenden Ansprüche, wobei das Verfahren weiter aufweist: zumindest teilweises Abtragen (232) des eingebrachten Füllmaterials (F).

12. Verfahren nach wenigstens einem der vorstehenden Ansprüche, wobei das Verfahren weiter aufweist: Anordnen (240) wenigstens einer sekundären elektrisch leitfähigen Schicht (105a, 105b) auf wenigstens einer Oberfläche der Schaltungsträgerplatte und/oder des Einsatzes (110; 110a).

13. Verfahren nach wenigstens einem der vorstehenden Ansprüche, wobei der wenigstens eine Einsatz (110; 110a) wenigstens ein Material mit einer Wärmeleitfähigkeit aufweist, die größer ist als die Wärmeleitfähigkeit des Grundkörpers (102), insbesondere wenigstens ein Keramikmaterial, vorzugsweise aufweisend Aluminiumnitrid.

14. Schaltungsträgerplatte (100; 100a; 100b; 100c) mit einem einen Faserverbundwerkstoff aufweisenden Grundkörper (102), wobei der Grundkörper (102) wenigsten eine Öffnung (104a) aufweist, wobei in der wenigstens einen Öffnung (104a) wenigstens ein Einsatz (110; 110a) so angeordnet ist, dass zwischen wenigstens einer Seitenwand (112) des Einsatzes (110; 110a) und einer Seitenwand (104a') der Öffnung (104a) wenigstens ein Spalt (106, 106a, 106b, 106c) verbleibt, wobei in dem wenigstens einen Spalt (106, 106a, 106b, 106c) zumindest bereichsweise ein Füllmaterial (F) angeordnet ist.

15. Schaltungsträgerplatte (100; 100a; 100b; 100c) nach Anspruch 14, wobei a) der Spalt (106, 106a, 106b, 106c) eine Breite (B) zwischen 0,0 Millimeter und 2,0 Millimeter aufweist, vorzugsweise zwischen 0,1 Millimeter und 0,4 Millimeter, weiter vorzugsweise zwischen 0,1 Millimeter und 0,2 Millimeter und/oder b) das Füllmaterial (F) ein, insbesondere synthetisches, Harz, insbesondere Epoxidharz, ist.

16. Schaltungsträgerplatte (100; 100a; 100b; 100c) nach wenigstens einem der Ansprüche 14 bis 15, wobei die wenigstens eine Öffnung (104a) eine polygonale Grundform mit abgerundeten Ecken aufweist, wobei die abgerundeten Ecken einen ersten Krümmungsradius (R1) aufweisen, wobei der wenigstens eine Einsatz (110; 110a) eine polygonale Grundform mit Ecken aufweist, wobei wenigstens eine Ecke (113) des Einsatzes (110; 110a) einen zweiten Krümmungsradius aufweist, der kleiner ist als der erste Krümmungsradius (R1).

17. Verwendung der Schaltungsträgerplatte (100; 100a; 100b; 100c) nach wenigstens einem der Ansprüche 14 bis 16 a) zur Aufnahme von wenigstens einer Wärmequelle (W), wobei die Wärmequelle (W) wenigstens ein elektrisches bzw. elektronisches Bauelement (B) aufweist, und b) zur Entwärmung des wenigstens einen Bauelements (B).
